# EUROPEAN PATENT SPECIFICATION

(11) **EP 4 407 394 B1**
(45) Date of publication and mention of the grant of the patent: **02.12.2026**
(21) Application number: 23153089.0
(22) Date of filing: 24.01.2023
(51) Int. Cl.: G05B 19/418

(54) **METHODS AND SYSTEMS FOR SIMULATING MODULE OPERATION OF A MODULE OF A MODULAR INDUSTRIAL PLANT**
VERFAHREN UND SYSTEME ZUR SIMULATION DES MODULBETRIEBS EINES MODULS EINER MODULAREN INDUSTRIEANLAGE
PROCÉDÉS ET SYSTÈMES DE SIMULATION DU FONCTIONNEMENT D'UN MODULE D'UNE INSTALLATION INDUSTRIELLE MODULAIRE

(43) Date of publication of application: 31.07.2024
(73) Proprietor: ABB SCHWEIZ AG, 5400 Baden (CH)
(72) Inventor: SCHOCH, Nicolai, 69120 Heidelberg (DE); STARK, Katharina, 69469 Weinheim (DE); HOERNICKE, Mario, 76829 Landau (DE)
(74) Representative: Maiwald GmbH

(56) References cited:
- WO-A1-2021/130311
- US-A1- 2020 110 390

## Description

### FIELD OF THE INVENTION

The invention pertains to methods and systems for modular plant control parameter determination of a modular industrial plant.

### BACKGROUND

The present invention concerns modular automation systems and modular plants. A goal for modular plants is to employ prefabricated and well-tested and well-understood modules, also referred to as PEAs (Process Equipment Assembly), that can be easily put together in different combinations so that different configurations (recipes) can be realized.

Modules are usually defined and created individually and then assembled into the overall plant. The standardized MTP approach may create a framework for interoperability between modules and orchestration system.

There are different application and use case scenarios, such as process plant Virtual Commissioning (VIBN), or process plant verification, which can, e.g., for time and cost efficiency reasons, be performed virtually before the actual installation of the modules and the deployment of the overall plant (which may comprise several modules that are piped together). For these scenarios, module simulation can bring large benefits.

Thus, it is a goal to be able to simulate modules individually and/or in the context of the overall plant, for example in order to ensure safe and efficient operation. Current simulations have shortcomings leading to a need to improve the quality of the simulations.

It is therefore an object of the present invention to provide methods and systems that address at least some of the above challenges, particularly, provide improved simulation quality and, particularly, thereby ensure safe and efficient operation.

### SUMMARY

At least some of the challenges are solved by the subject-matter of the present disclosure. The invention provides methods, systems, a computer readable medium, and a computer program product according to the independent claims. Preferred embodiments are laid down in the dependent claims.

The invention provides a computer-implemented method according to claim 1.

The invention provides another computer-implemented method according to claim 2.

The invention provides yet another computer-implemented method according to claim 3.

The method according to claim 3 combines the approaches of the first and second method by first applying knowledge-based enhancement and then data-driven enhancement, e.g., data assimilation. For example, the initial simulation may be enhanced to perform bias correction and/or fringe-case correction and, subsequently, data assimilation may be carried out for calibration. The data assimilation may concern the first enhanced model directly or indirectly by modifying and/or improving/adapting rules.

Simulating module operation of the module, in the present disclosure, may relate to operation of a single module in isolation.

A module may, for example, be a heating module (e.g., for heating up oil in refining plants, or for power generation), a mixing module (for mixing fluids, with consideration of sedimentation, etc.), a reaction module (for chemical reactions), a separation module (e.g. for three-phase-separation of gas, water, oil), or the like.

A modular industrial plant may be any industrial plant comprising multiple, potentially different, modules. The modules of an industrial plant may be part of a module chain or module topology. Plant operation may, thus, include operation of one or more of the multiple modules, e.g., at least in part interdependently.

The term white-box simulation, in the present disclosure, may comprise hard-coded models and/or simulation algorithms, which may in particular be based on the rules of physics and/or engineering.

The term black-box simulation, in the present disclosure, may comprise machine-learning based module simulation. Black-box simulations may comprise (real-life) data-driven and Al-enhanced simulation. For example, machine-learning based module simulation functionalities, for example neural networks that mimic the behavior of the real system and that were trained with real-life data.

The term grey-box simulation, in the present disclosure, may comprise combinations of the white-box and black-box simulations, i.e., simulations, parts of which are based on clearly understandable program code, programmed/created explicitly and manually by e.g. a module or MTP manufacturer, and based on, e.g., C&E simulation, etc., combined with parts which are based on (black-box) NNs or ML & DA algorithms, which are not fully transparent to the user, but which got trained on real application data, and are therefore not fully-white-box, but which still serve to approximate some (partial) functions or parts of the overall simulation. Example: Module simulation of a reactor, where a certain part is based on a C&E simulation or with several if-else-loops, which is clearly white-box, and another part is based on a data-driven, ML-based function approximation which describes a sub-part of the overall module simulation, e.g., only the heating behavior inside a reactor, but which is black-box (meaning, data-driven, learned-by-training, and not e.g. hard-coded if-else loops, etc.).

Obtaining an enhanced model, according to the present disclosure, may comprise modifying or extending a model in such a manner as to improve accuracy. Modifying a model may comprise restricting the ranges of variables and/or parameters, calibrating simulation model parameters, updating and/or improving functional dependencies according to data-based correlations or patterns, etc. Extending a model may comprise e.g. the extension of a functional dependency by means of a further physical quantity and/or engineering quantity, and/or the consideration of an additional engineering rule, which describes or restricts certain behaviors, and/or a rule that takes care of specific physical or engineering constraints, etc.

Performing a knowledge-based modification of a model may comprise modifying the model in such a manner as to take into account the knowledge. Performing a knowledge-based extension of a model may comprise extending the model in such a manner as to take into account the knowledge.

The knowledge-based modification and/or the knowledge-based extension each models domain knowledge and/or enforces domain rules. Domain knowledge and domain rules may comprise knowledge/rules pertaining to industrial process automation and/or engineering domain knowledge. It may be provided, for example, by operators.

Domain knowledge may refer to typical engineering-education-based configurations of modules, typical (physics-based) dependencies between parameters, typical co-occurrences of settings or parameters, common or standard settings/configurations, best practices in engineering, established and proven suitable ranges of parameters or variables, etc.

For example, domain knowledge may comprise information about non-linear (functional) behaviors and/or interdependencies and/or correlation between multiple variables and/or fringe cases etc.. In particular, knowledge may comprise information not reflected in stored and/or collected data (e.g. for training ML algorithms) used for building the initial model and/or data, e.g., parameters. that are not generally taken into account for the modelling. In particular, domain knowledge may also comprise information that can make up for non-data-centric ML-based models, i.e., models that have been trained on e.g. unintentionally biased or poorly-selected training data.

The knowledge-based extension or modification, in the present disclosure, may entail rule-based extension or modification. For examples, rules may be provided so as to address potential bias due to biased collected data that is used for white-box simulation and/or provided so as to address lack of information concerning fringe cases in the collected data or from the database data that is used for white-box simulation.

Knowledge may also be module-specific and relate to knowledge about non-linear (functional) behavior, interdependencies and/or correlation between multiple variables that are not reflected in collected data or that are not generally taken into account for the modelling as they are not in a database from which data for obtaining the initial model are stored.

The term "data-driven" may refer to being driven by measurement data obtained for the module in operation being installed as part of the modular industrial plant.

Performing a data-driven modification of a model may comprise modifying the model in such a manner as to take into account measurement data obtained for the module in operation being installed as part of the modular industrial plant.

Performing a data-driven extension of a model may comprise extending the model in such a manner as to take into account measurement data obtained for the module in operation being installed as part of the modular industrial plant.

Data-driven enhancement may comprise data-assimilation, e.g. comprising an optimization. Data assimilation may, for example, be carried out by means of an optimization engine that improves or calibrates black-box or white-box simulation setups (e.g., parameters and relations). This may be done based on assimilating the simulated simulation scenario behavior to real-life data, e.g., by means of calibrating parameters or dependencies.

Claim 1 proposes a knowledge-based enhancement step, claim 2 proposes a data-driven enhancement step, and claim 3 proposes two enhancement steps, i.e. a knowledge-based and a data-driven enhancement step.

It is noted that claims 1 to 3 have been drafted as independent claims. As can be understood from the above, they provide alternative, yet unitary solutions. To ensure readability, particularly of the dependent claims, it is most appropriate to cover these alternatives not by a single claim, but rather by individual claims.

It can be seen from the above that the present disclosure provides methods that provide module simulation functionalities, e.g., to the plant owner.

As an example, a basic (initial) model may be used that makes use of modeling-relevant information that can be derived from the process and automation engineering sources (DEXPI, MTP, etc), i.e., a white-box approach, and/or makes use of out-of-the-box data-driven ML-based mechanisms to learn model/simulation setups, i.e., a black-box approach. It enhances this basic/initial model with knowledge-based and/or data-assimilation and/or optimization mechanisms to thus overcome the typical shortcomings of the basic approaches, thereby allowing for correct/accurate and inexpensive module simulation functionalities.

It will be outlined in detail below that additionally, an optional simulation-based optimization component can be added, e.g. to facilitate simulation-in-the-loop and to thus provide data-flow-driven simulation-based control parameter optimization suggestions.

Moreover, as also outlined in detail below, the method may rely on data acquisition, e.g., carried out by data acquisition hardware like sensors/measurement devices.

As explained above, in order to obtain module simulation functionalities, for the initial model a white-box simulation or a black-box simulation may be employed.

As an example, white box simulation functionality may be provided by a dedicated, white-box simulation program code that was programmed/created manually by the module- or MTP-manufacturer, that is based on, e.g., a C&E simulation, and that can be derived from and executed following the information provided in the MTP or other sources (e.g., from process engineering, e.g., DEXPI). As another example, black-box simulation functionality may be provided by a real-life data-driven and Al-enhanced black-box simulation that was not programmed manually (e.g. by the module manufacturer), but that simulates (i.e., approximates) the module's behavior based on a Neural Network or ML-algorithm that has been trained on real-life training data.

The present disclosure further provides enhancing the simulation by at least one of a knowledge-based approach and a data-driven, e.g., a data-assimilation, approach. A knowledge-based approach may be provided, which models and enforces domain knowledge, e.g., industrial process automation and engineering domain knowledge. Hence it may take care of, e.g., the simulation not breaking essential domain rules. It may also, accordingly, ensure explainability of the underlying algorithms, and boost transparency and credibility. A data-driven approach may be provided, for example, in the form of a data-assimilation (optimization) engine that improves or calibrates (black-box or white-box/hard-coded) simulation parameters based on assimilating the simulated simulation scenario behavior to real scenario data.

As an example, the white-box approach, to achieve high precision, may require much manual effort and high domain expertise to properly model the module behavior. The black-box approach, when out-of-the-box, usually is not entirely suitably calibrated, i.e., it may not cover all possible cases (as some error cases might very seldomly occur in real plants) and usually does not fine-granularly represent the real behavior.

The enhancing steps may address these and other challenges, such as missing or not completely correct representation/simulation of the simulated behavior when compared to the real behavior, or partially incomplete simulation model along with the incomplete consideration of control parameters which affect the overall simulated behavior.

According to the present disclosure, as part of the knowledge-based enhancement step, a rule-based bias and/or fringe case correction may be performed, and subsequently, as part of the data-driven enhancement step, a data assimilation may be performed for calibration of the first enhanced model and/or for calibration of one or more rules of the rule-based bias and/or fringe case correction.

Thus, a particularly precise model can be obtained in a structured and efficient manner.

According to the present disclosure, the knowledge-based enhancement step may be based on module-specific knowledge comprising at least one of information on correlation between multiple variables, information on linear or non-linear functional behavior, information on interdependencies, information on fringe cases, information on bias in input data, information on potentially relevant additional simulation parameters.

Thus, a particularly accurate and comprehensive simulation can be obtained.

Module-specific knowledge may refer to knowledge that is specific to a module type or to an individual module.

Information on non-linear (functional) behavior may comprise information indicating that a parameter/variable representative of the operation characteristics of the module has a non-linear correlation with another parameter/variable at least for a partial range of values of said other parameter/variable, e.g., at values above or below certain thresholds.

Information on correlation between multiple variables may, for example, comprise information on a correlation between a parameter/variable representative of the operation characteristics of the module and another parameter/variable. Such information may comprise indications of linear and/or non-linear (functional) behavior, for example.

Information on interdependencies may comprise information an influence of a first parameter/variable on a second parameter's/variable's correlations with a third parameter/variable. It may include information on non-linear (functional) behavior, e.g., of the second parameter/variable, caused by the first parameter/variable. For example, a pressure dependency of the second variable may be influenced by a temperature, or the like.

Information on fringe cases may refer to information that concerns rare scenarios, i.e., scenarios that are unlikely to occur. Information on fringe cases may contain information describing the fringe case and optionally information on how the fringe case is to be addressed in a simulation/model. Such fringe cases and/or information thereon may be provided and identified as such by a user, e.g., an operator.

Bias in input data may stem from a non-data-centric approach for acquisition of data or from incomplete acquisition of data or the like. Information on bias in input data may contain an indication that data is biased and optionally information on how the data is biased and/or how the bias is to be addressed in a simulation/model. Such bias and/or information thereon may be provided and identified as such by a user, e.g., an operator.

Information on potentially relevant additional simulation parameters may refer to parameters that would initially not be included in a simulation, e.g. due to assumed low relevance. Information on potentially relevant additional simulation parameters may contain an indication of potentially relevant additional simulation parameters and optionally information on how the potentially relevant additional simulation parameters is to be taken into account in a simulation/model. Such parameters and/or information thereon may be provided and identified as such by a user, e.g., an operator.

According to the present disclosure, the modelling of domain knowledge may comprise modelling the module-specific knowledge and/or wherein enforcing of domain rules may comprise enforcing rules that implement the module-specific knowledge.

Enforcing domain rules, in this context, may refer to making sure that certain values always stay above or below certain allowed thresholds, or that specific HAZOP (Hazard and Operability) guidelines are obeyed to, or that best practices are considered/taken into account and/or not ignored or forgotten, or that common mutual engineering exclusion criteria are taken into account and not violated, etc.

According to the present disclosure, the data-driven enhancement step may comprise performing a data-driven modification and/or extension that comprises data-assimilation configured to minimize a difference between simulation output data and actual measurement data, e.g., employing a Kalman Filter.

In other words, the data-driven enhancement step may comprise modifying and/or extending the model such that its predictions concerning module operation more closely match measurements representative of module operation.

According to the present disclosure, the data-driven enhancement step may comprise performing a data-driven modification and/or extension comprising, e.g. after installation of a module, a module-specific calibration of the initial model, in particular initial model simulation parameters and/or initial model relations.

The present disclosure provides a method for modular plant control parameter determination. Plant control parameters may be any parameters suitable to control plant operation, e.g., values of operation parameters of the plant and/or its components.

According to the present disclosure, an optimization step may comprise a data-driven optimization based on simulation data and/or measurement data obtained for the modular industrial plant operation.

Thus, an (optional) optimization component for simulation-in-the-loop may be provided. This allows for providing a data-flow-driven simulation-based control parameter optimization suggestion.

Optimization may be performed for a module chain or topology, comprising multiple modules, for example from the same or different manufacturers and/or of same or different types, in parallel and/or in series. The optimization allows for modelling interrelations between the modules that are not reflected in the individual models and, particularly, in the database data.

For example, the individual modules and an overall module-to-module process chain or pipeline may be taken into account for the optimization, e.g., by providing an inter-module calibration. Thus, as an example, bottlenecks or module downtime can be prevented (e.g. due to a certain module being in a certain place in a module chain). Moreover, it may be determined for a plurality of modules, e.g. for two or more parallel modules, how to operate the modules so as to use excess power from one module to power other module(s). Thus, the overall process plant performance is boosted.

The present disclosure also provides a system comprising a computing system configured to carry out the method for simulating module operation of a module of a modular industrial plant of the present disclosure, e.g., as outlined above.

The system according to the present disclosure may further comprise one or more sensors/measurement devices configured to obtain measurement data for the module in operation being installed as part of the modular industrial plant and/or measurement data for the modular industrial plant operation.

The system according to the present disclosure may also comprise the module of the modular industrial plant.

The proposed overall system for module simulation may comprise a software component to virtually perform the method steps, and one or more hardware components, e.g. for sensing and/or monitoring and/or encoding and/or processing, to facilitate the data acquisition, processing and computation parts.

The computer-implemented method may, for example make use of complementary data acquisition hardware like sensors/measurement devices.

The computing system may comprise one or more computing devices and, particularly, may be a distributed computing system.

The present disclosure also provides a computer program product comprising instructions which, when the program is executed by a computing system, cause the computing system to carry out any of the methods of the present disclosure.

The invention also provides a computer-readable medium comprising instructions which, when executed by a computing system, cause the computing system to carry out any of the methods of the present disclosure.

The features and advantages outlined above in the context of the methods similarly apply to the systems, computer program product, and computer-readable medium described herein.

Further features, examples, and advantages will become apparent from the detailed description making reference to the accompanying drawings.

### BRIEF DESCRIPTION OF THE DRAWINGS

In the accompanying drawings,
Fig. 1 is a flowchart schematically illustrating a first method according to the present disclosure;
Fig. 2 is a flowchart schematically illustrating a second method according to the present disclosure;
Fig. 3 is a flowchart schematically illustrating a third method according to the present disclosure;
Fig. 4 is a schematic illustration of a system according to the present disclosure; and
Figs. 5a to 5c illustrate systems and methods according to the present disclosure.

### DETAILED DESCRIPTION

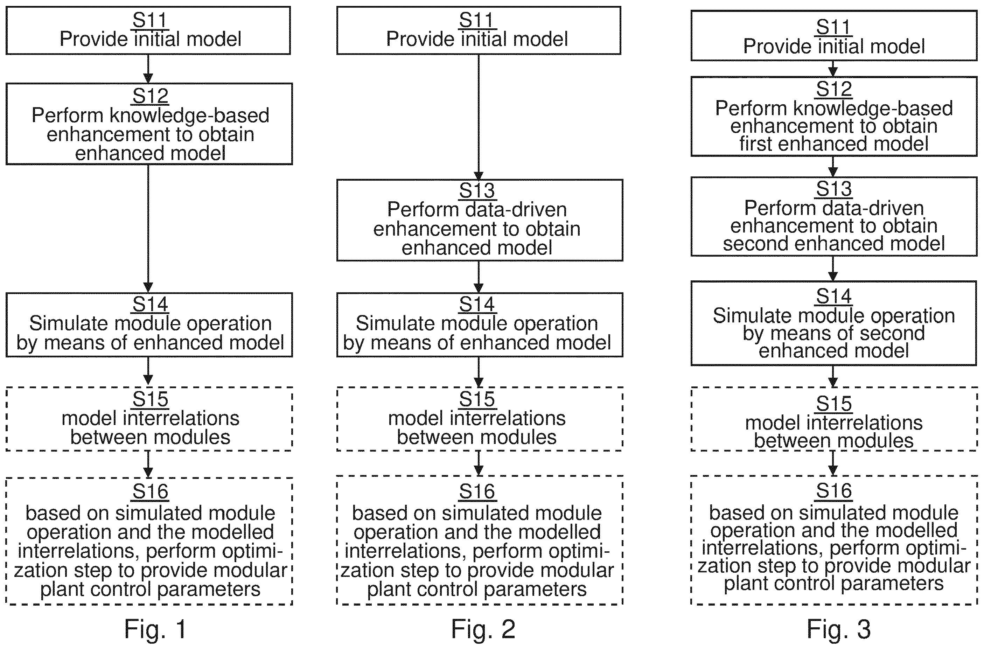

Fig. 1 is a flowchart schematically illustrating a computer-implemented method for simulating module operation of a module of a modular industrial plant. The method comprises step S11 of providing an initial model for the module based on a white-box simulation or a black-box simulation.

The method comprises step S12 of performing a knowledge-based enhancement step, comprising obtaining an enhanced model by performing a knowledge-based modification of the initial model and/or a knowledge-based extension of the initial model. The knowledge-based modification and/or the knowledge-based extension each models domain knowledge and/or enforces domain rules. The method further comprises step S14 of simulating module operation of the module by means of the enhanced model.

Fig. 2 is a flowchart schematically illustrating a computer-implemented method for simulating module operation of a module of a modular industrial plant. The method comprises step S11 of providing an initial model for the module, for example based on a white-box simulation or a black-box simulation or a grey-box simulation.

The method comprises step S13 of performing a data-driven enhancement step, comprising obtaining an enhanced model by performing a data-driven modification of the initial model and/or a data-driven extension of the initial model. The data-driven modification and/or the data-driven extension each is based on measurement data obtained for the module in operation being installed as part of the modular industrial plant. The method further comprises step S14 of simulating module operation of the module by means of the enhanced model.

Fig. 3 is a flowchart schematically illustrating a computer-implemented method for simulating module operation of a module of a modular industrial plant. The method comprises step S11 of providing an initial model for the module based on a white-box simulation or a black-box simulation.

The method comprises step S12 of performing a knowledge-based enhancement step, comprising obtaining a first enhanced model by performing a knowledge-based modification of the initial model and/or a knowledge-based extension of the initial model. The knowledge-based modification and/or the knowledge-based extension each models domain knowledge and/or enforces domain rules.

The method comprises step S13 of performing a data-driven enhancement step, comprising obtaining a second enhanced model by performing a data-driven modification of the first enhanced model and/or a data-driven extension of the first enhanced model. The data-driven modification and/or the data-driven extension each is based on measurement data obtained for the module in operation being installed as part of the modular industrial plant.

As an example, as part of the knowledge-based enhancement step, a rule-based bias and/or fringe case correction is performed, and subsequently, as part of the data-driven enhancement step, a data assimilation is performed for calibration of the first enhanced model and/or for calibration of one or more rules of the rule-based bias and/or fringe case correction.

The method further comprises step S14 of simulating module operation of the module by means of the second enhanced model.

In all of the above-described methods that include a knowledge-based enhancement step, the knowledge-based enhancement step may be based on module-specific knowledge comprising at least one of information on correlation between multiple variables, information on non-linear (functional) behavior, information on interdependencies, information on fringe cases, information on bias in input data, information on potentially relevant additional simulation parameters. The modelling of domain knowledge may comprise modelling the module-specific knowledge and/or wherein enforcing of domain rules comprises enforcing rules that implement the module-specific knowledge.

In all of the above-described methods that include a data-driven enhancement step, the data-driven enhancement step may comprise performing a data-driven modification that comprises data-assimilation configured to minimize a difference between simulation output data and actual measurement data, e.g., employing a Kalman Filter. Alternatively or in addition, the data-driven enhancement step comprises performing a data-driven modification comprising, after installation of a module, a module-specific calibration of the initial model, in particular initial model simulation parameters and/or initial model relations.

Figs. 1 to 3 also, by ways of optional steps S15 and S16, schematically illustrate a computer-implemented method for modular plant control parameter determination according to the present disclosure, the method comprising the method for simulating module operation of a module of a modular industrial plant according to the present disclosure, including steps S11, S12 and/or S13, and S14, e.g., as outlined above.

The method for modular plant control parameter determination comprises, in step S15 modelling interrelations between modules of the modular industrial plant, and, in step S16, based on the simulated module operation of the module and the modelled interrelations, performing an optimization step so as to provide modular plant control parameters. The optimization step may comprise a data-driven optimization based on simulation data and/or measurement data obtained for the modular industrial plant operation.

It is to be understood that at least some of the above steps are optional and may be omitted.

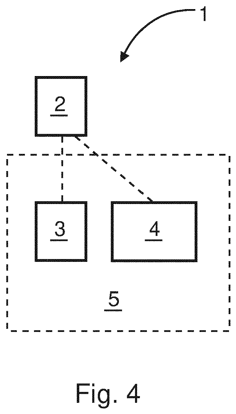

Fig. 4 illustrates a system 1 comprising a computing system 2 configured to carry out the method according to the present disclosure, e.g. as outlined in the context of Figures 1 to 3. The system in this example, optionally, further comprises a sensor 3, and may optionally comprise multiple sensors, the/each sensor configured to obtain measurement data for the module in operation being installed as part of the modular industrial plant and/or measurement data for the modular industrial plant in operation. The system in this example, optionally, further comprises the module 4 of the modular industrial plant 5.

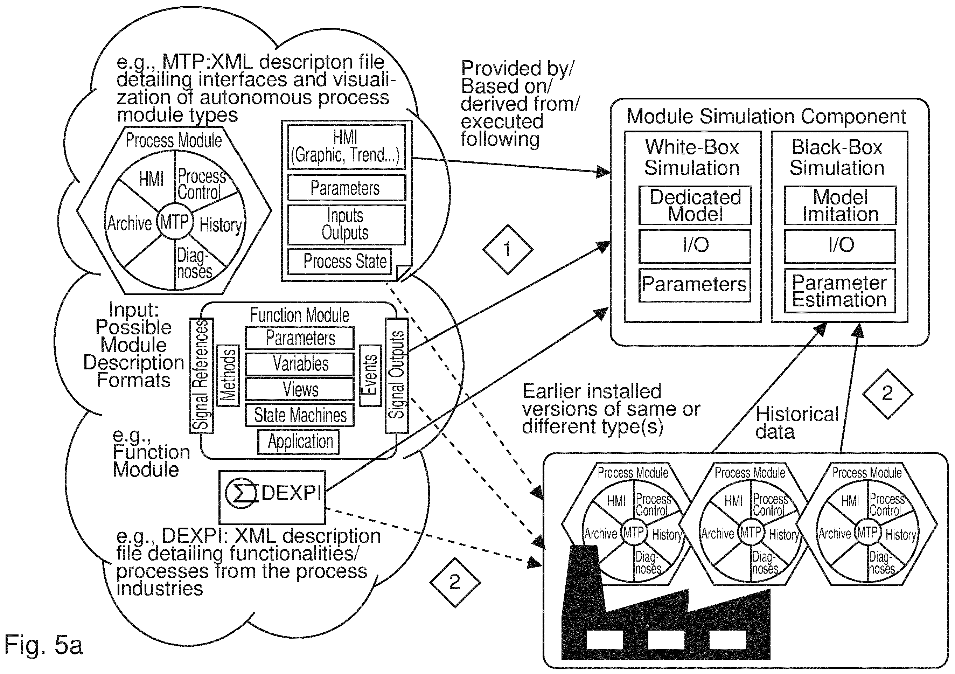

Some further aspects and examples of the present disclosure will be outlined below making reference to Figs. 5a to 5c.

The systems and methods of the present disclosure, particularly outlined below, enable and facilitate better (i.e., realistically modelled/simulated, accurate, sensible, well-calibrated, easy-to-set-up) module simulation functionalities for different scenarios in the modular industrial automation and process engineering domains.

Provided, in this example, is a method and system that provide a first step of coarse module simulations (Fig. 5a), where a coarse (also referred to as initial) simulation is a simulation that is not exact enough to e.g. tune parameters of a PID-controller but works for e.g. testing interlocks.

In the first step, at least one of two main base approaches may be employed, which may provide a coarse module simulation (out-of-the-box):
1. Dedicated, white-box Module Simulation that was programmed/created manually by the module- or MTP-manufacturer, that is based, e.g., on a C&E simulation, and that can be derived from and executed following the information provided in the MTP or other sources (e.g., from process engineering, e.g., DEXPI).
2. Real-life Data-driven and Al-enhanced black-box Module Simulations that were not programmed manually by the module manufacturer, but that simulate the module's behavior based on what the Neural Network or ML-algorithm has learned based upon the provided real-life training data (provided e.g. from an existing installation of the respective modules/PEAs).

The first approach requires large manual efforts and high domain expertise to properly model the module behavior, e.g., by deriving the basic structure/setup of model and simulation from the contents of the MTP or other process industry typical sources (DEXPI, FM, etc.). This approach may yield (if a domain and simulation expert puts in large efforts) good physical/chemical equations-based models with default parameters, however, e.g., the parameters may not be properly calibrated.

The second approach, when out-of-the-box, may not yet be suitably/completely calibrated either, and, in particular, may not necessarily cover/model all possible cases (as some error cases might very seldomly occur in real plants), and usually does not fine-granularly represent the real behavior. This is mainly due to the missing underlying physics/chemistry behavior model, and due to possibly sub-optimal training data (which, e.g., may not represent the full picture and complete behavior, but only part of the actual overall behavior or only the behavior during a limited sub-period in time).

Thus, both approaches require high efforts and costs or bring along difficulties, challenges and impediments.

Difficulties and impediments, e.g., consist in the missing or not completely correct representation/simulation of the simulated behavior when compared to the real behavior, or the partially incomplete simulation model along with the incomplete consideration of control parameters which affect the overall simulated behavior.

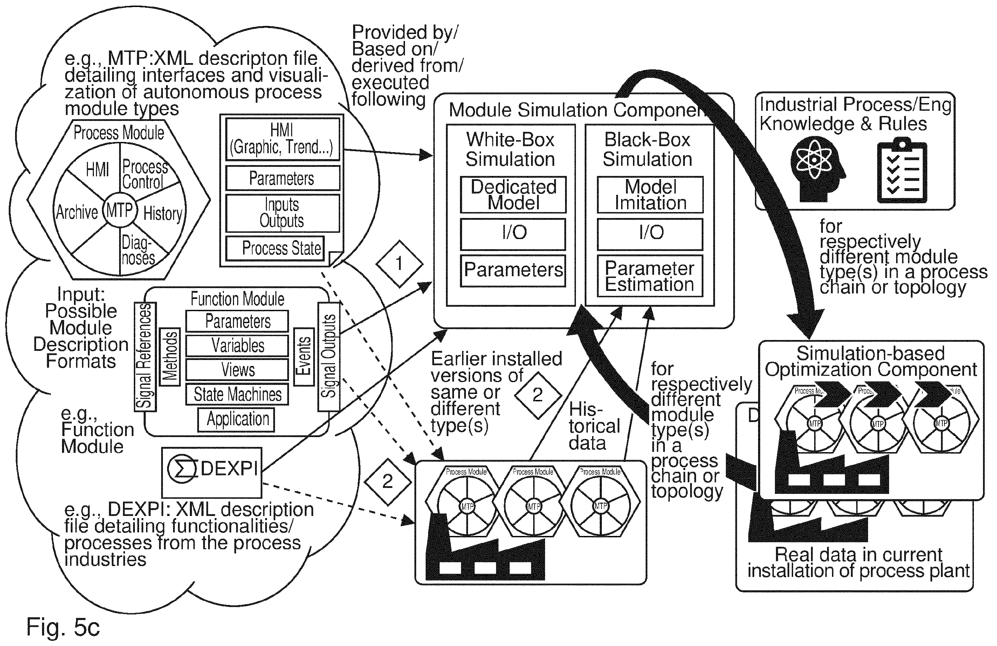

To address the above, in a next step, the initial/coarse module simulations are enhanced by means of one or more of:
a) a knowledge-based approach (marked with "a" in Fig. 5c), which models and enforces (industrial process automation and engineering) domain knowledge and hence takes care of, e.g., the simulation not breaking essential domain rules (thus also offering explainability of the underlying algorithms, and boosting transparency and credibility);
b) a data-assimilation (optimization) engine that improves or calibrates (black-box or hard-coded) simulation parameters based on assimilating real scenario data to the simulated simulation scenario behavior (marked with "b" in Fig. 5c).

The proposed overall system for module simulation hence may comprise a software component to virtually perform the above tasks, and optionally (in case of the data-assimilation) a hardware component for at least one of sensing, monitoring, recording, processing to facilitate the data acquisition, processing, and computation parts.

The software component for part (a) is to particularly overcome the drawbacks and shortcomings of the real-life-data-driven and Al-enhanced black-box module simulation component that learns to simulate the modules' behavior based on what the Neural Network (NN) or ML-algorithm has come up with based upon the provided real-life training data. Namely, it is to check if the NN-representation is consistent with the intended target representation of the module/process functionality. For instance, in a reaction module with a capacitive level sensor and regulation to measure and balance the filling level, a long (data recording) period of "no-fill" may be misinterpreted by the NN to be the 'always-true' default value, but should not be. Hence, the knowledge representation component is responsible for still integrating this parameter into the model - and for bringing up to the user that a value here could not be set in consistency with the underlying modeling knowledge (requiring further data acquisition, e.g. through taking into account another period in time, where the capacitive level sensor does not measure "no-fill" values.

The implementation here may be based on a penalty mechanism, that penalizes data-driven NN-based simulation behavior that contradicts engineering/physics knowledge/rules. Alternatively, the implementation may build upon physics-based machine learning algorithms (or model-based machine learning algorithms) where e.g. forward and backward propagation are restricted to only allow physically-reasonable behavior, or make use of reinforcement learning algorithms where a virtual agent assesses the NNs-based simulated behavior of a given module against a physical/chemical/engineering potential behavior and penalizes the resulting error, thus improving the weights in the NN representation, and hence iteratively improving the actual simulation itself.

On the other hand, the software component for part (b) is to particularly overcome the drawbacks and shortcomings of the dedicated, white-box Module Simulation component that was programmed/created manually by the module- or MTP-manufacturer, that is based, e.g., on a C&E simulation, or that can be derived from and executed following the information provided in the MTP or other sources (e.g., from process engineering, e.g., DEXPI). As has been explained above, these shortcomings mainly result from the fact that only the basic structure/setup of model and simulation can be derived from the contents of the MTP or from other process industry typical sources (DEXPI, FM, etc.), and that this approach may hence yield good physical/chemical equations-based models with default parameters, however, e.g., the parameters may not yet be properly calibrated.

Therefore, part (b) may overcome this using mathematical methods for data-assimilation, i.e., mathematical optimization in the sense of minimizing the error between real behavior that is measured in the recorded data and the simulated behavior based on the not-yet-calibrated model. The data assimilation engine hence is to "improve" or calibrate (possibly both, black-box or hard-coded) simulation parameters based on assimilating real scenario data to the simulated simulation scenario behavior.

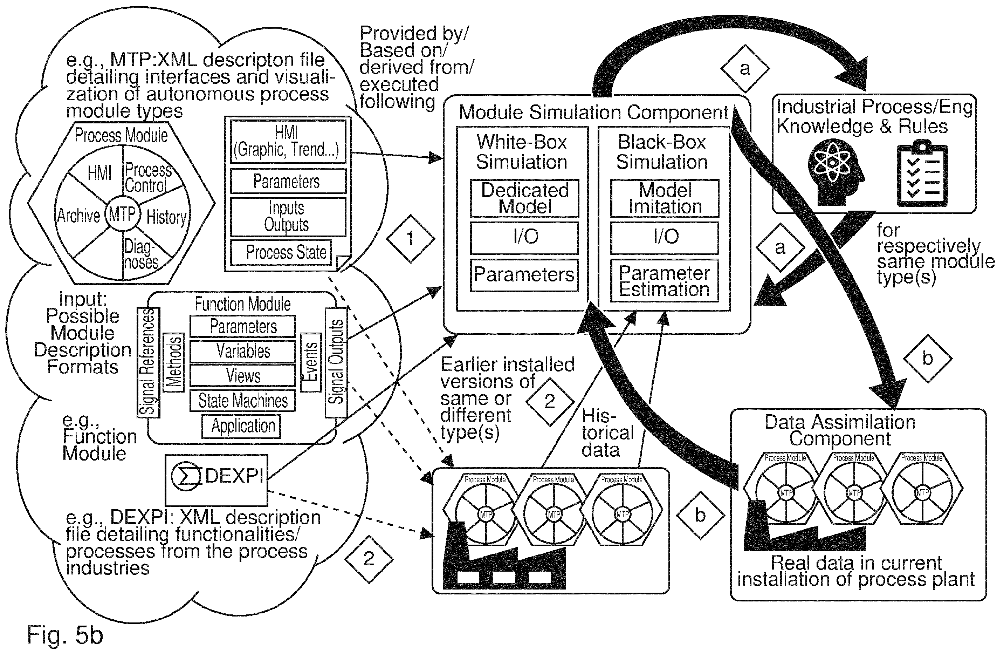

While Figs. 5a and 5b concern dealing with one type of module, and hence, with calibration/tuning of one module's simulation, Fig. 5c illustrates handling a chain/topology of modules, which may even comprise different types of modules.

When simulating the modules and the overall module-to-module process chain/pipeline, a "cheap" add-on feature consists in optimization of the inter-module calibration, e.g., to prevent bottlenecks or module downtimes, and to thus boost the overall process plant performance.

Therefore, an additional (optional) simulation-based optimization component with simulation-in-the-loop to be added on top of the above-described system may be provided, e.g., in order to provide the plant owner with data-flow-driven simulation-based control parameter optimization suggestions.

Hence, a chain or topology of (possibly different) modules is provided. A chain may be a sequence of modules after one another. A topology may also include parallel modules or module chains that feed or consume to/from one next/previous module, including multi-input/output, etc.

Through having simulation-in-the-loop with the actual installed chain/topology of modules, back-and-forth / iterative optimization is facilitated.

For example, strict parameter requirements and real-life data from the plant may be fed to the simulation and optimization engine for integrating these into their computations, and, based thereon, again come up with an overall better-optimized combined set of parameters for all modules used in the respective chain/topology.

In the other direction, it is possible to simulate and optimize, based on different what-if-scenarios that comprise different module settings and parameter combinations, and computer the remaining tuneable parameters in a way such that the real module chain/topology is optimal with respect to the given criteria.

Possible criteria may be the minimization of module downtimes, or the avoidance of bottlenecks, or the reduction of energy costs, etc.

As can be seen from the above description of different methods and systems of the present disclosure, the following effects can be provided:
a) To have a system that allows to obtain reasonably applicable and correct/accurate and relatively cheap simulation functionalities: (a-priori) Simulation per-se can provide a cheaper alternative (or predecessor) to real commissioning and post-commissioning-failure or be used for process plant verification.
b) Out-of-the-box simulation usually requires high efforts and costs, and brings along difficulties, challenges, problems and impediments. Yet, the suggested enhanced solution approach helps automate many parts, thereby further reducing the costs/efforts, and helps improving problems and disadvantages associated with simulations (not being accurate enough, not being well-calibrated when out-of-the-box, hard to setup, hard to understand, etc.) by means of additional functionalities (knowledge-based approach and/or data-assimilation engine, plus optional optimization component).
c) Real data-driven, engineering-knowledge-based calibration and fine-tuning of simulation model parameters and control features, in order to obtain useful module simulation functionalities, that allow for making use of virtual module simulation in application scenarios such as VIBN, plant verification, etc.
d) Explainable, transparent, resilient and credible simulation model calibration, thanks to a combination of (black-box) ML algorithms (to work evidence-based with the provided plant data) and (white-box) knowledge representation algorithms (that represent well-defined, expert-based engineering knowledge and knowledge models).
e) Module and module-to-module optimization, when using the additional (optional) optimization component with simulation-in-the-loop, which can provide the plant owner with data-flow-driven simulation-based control parameter optimization suggestions to further boost plant performance.
f) Simplify the pre-deployment processes and hence allow to save time and cost during deployment and also being able to detect sub-optimal parameter settings through the system's optimization component and suggest according improvements to the control engineer.

To summarize, the present disclosure provides a system that allows to obtain reasonably applicable, correct/accurate, and relatively cheap module simulation functionalities. It may combine different approaches for setting up module simulations and simulation models that on the one hand makes use of modeling-relevant information that can be derived from the automation and process engineering sources (DEXPI, MTP, etc), and on the other hand use data-driven ML-based mechanisms to learn model/simulation setups.

It may enhance these basic setups with knowledge-based and/or data-assimilation-based enhancement and optimization mechanisms to thus overcome the typical shortcomings of the basic approaches, thereby allowing for reasonably applicable, correct/accurate, and relatively cheap module simulation functionalities.

Additionally, an optional simulation-based optimization component can be added to facilitate simulation-in-the-loop and to thus provide the plant owner with data-flow-driven simulation-based control parameter optimization suggestions.

While the invention has been illustrated and described in detail in the drawings and foregoing description, such illustration and description are to be considered exemplary and not restrictive. The invention is not limited to the disclosed embodiments. In view of the foregoing description and drawings it will be evident to a person skilled in the art that various modifications may be made within the scope of the invention, as defined by the claims.

## Claims

1. A computer-implemented method for modular plant control parameter determination of a modular industrial plant comprising a plurality of modules, the method comprising:
a method for simulating module operation of a module of the modular industrial plant comprising
providing an initial model for the module (S11) based on a simulation, particularly a white-box simulation or a black-box simulation or a grey-box simulation,
performing a knowledge-based enhancement step (S12), comprising obtaining an enhanced model by performing a knowledge-based modification of the initial model and/or a knowledge-based extension of the initial model, wherein the knowledge-based modification and/or the knowledge-based extension each models domain knowledge and/or enforces domain rules, and
simulating (S14) module operation of the module by means of the enhanced model;
the method for modular plant control parameter determination further comprising:
modelling (S15) interrelations between modules of the modular industrial plant; and
based on the simulated module operation of the module and the modelled interrelations, performing (S16) an optimization step so as to provide modular plant control parameters.

2. A computer-implemented method for modular plant control parameter determination of a modular industrial plant comprising a plurality of modules, the method comprising:
a method for simulating module operation of a module of the modular industrial plant comprising
providing an initial model for the module (S11) based on a simulation, particularly a white-box simulation or a black-box simulation,
performing a data-driven enhancement step (S13), comprising obtaining an enhanced model by performing a data-driven modification of the initial model and/or a data-driven extension of the initial model, wherein the data-driven modification and/or the data-driven extension each is based on measurement data obtained for the module in operation being installed as part of the modular industrial plant, and simulating (S14) module operation of the module by means of the enhanced model;
the method for modular plant control parameter determination further comprising:
modelling (S15) interrelations between modules of the modular industrial plant; and
based on the simulated module operation of the module and the modelled interrelations, performing (S16) an optimization step so as to provide modular plant control parameters.

3. A computer-implemented method for modular plant control parameter determination of a modular industrial plant comprising a plurality of modules, the method comprising:
a method for simulating module operation of a module of the modular industrial plant comprising
providing an initial model for the module (S11) based on a simulation, particularly a white-box simulation or a black-box simulation, performing a knowledge-based enhancement step (S12), comprising obtaining a first enhanced model by performing a knowledge-based modification of the initial model and/or a knowledge-based extension of the initial model, wherein the knowledge-based modification and/or the knowledge-based extension each models domain knowledge and/or enforces domain rules,
performing a data-driven enhancement step (S13), comprising obtaining a second enhanced model by performing a data-driven modification of the first enhanced model, wherein the data-driven modification and/or the data-driven extension each is based on measurement data obtained for the module in operation being installed as part of the modular industrial plan, and
simulating (S14) module operation of the module by means of the second enhanced model;
the method for modular plant control parameter determination further comprising:
modelling (S15) interrelations between modules of the modular industrial plant; and
based on the simulated module operation of the module and the modelled interrelations, performing (S16) an optimization step so as to provide modular plant control parameters.

4. The method of claim 3, wherein, as part of the knowledge-based enhancement step, a rule-based bias and/or fringe case correction is performed, and subsequently, as part of the data-driven enhancement step, a data assimilation is performed for calibration of the first enhanced model and/or for calibration of one or more rules of the rule-based bias and/or fringe case correction.

5. The method of claim 1, 3, or 4, wherein the knowledge-based enhancement step is based on module-specific knowledge comprising at least one of information on correlation between multiple variables, information on linear or non-linear functional behavior, information on interdependencies, information on fringe cases, information on bias in input data, information on potentially relevant additional simulation parameters.

6. The method of claim 5, wherein the modelling of domain knowledge comprises modelling the module-specific knowledge and/or wherein enforcing of domain rules comprises enforcing rules that implement the module-specific knowledge.

7. The method of any of claims 2 to 6, wherein the data-driven enhancement step comprises performing a data-driven modification and/or extension that comprises data-assimilation configured to minimize a difference between simulation output data and actual measurement data, e.g., employing a Kalman Filter.

8. The method of any of claims 2 to 7, wherein the data-driven enhancement step comprises performing a data-driven modification and/or extension comprising, after installation of a module, a module-specific calibration of the initial model, in particular initial model simulation parameters and/or initial model relations.

9. The method of any of the preceding claims, wherein the optimization step comprises a data-driven optimization based on simulation data and/or measurement data obtained for the modular industrial plant operation.

10. A system (1) comprising a computing system (2) configured to carry out the method of any of claims 1 to 9.

11. The system according to claim 10, the system further comprising one or more sensors (3) configured to obtain measurement data for the module in operation being installed as part of the modular industrial plant and/or measurement data for the modular industrial plant in operation.

12. The system according to claims 10 or 11, further comprising the module (4) of the modular industrial plant (5).

13. A computer program product comprising instructions which, when the program is executed by a computing system, cause the computing system to carry out the method of any of claims 1 to 9.

14. A computer-readable medium comprising instructions which, when executed by a computing system, cause the computing system to carry out the method of any of claims 1 to 9.

## Patentansprüche

1. Computerimplementiertes Verfahren zur Bestimmung von Steuerungsparametern für eine modulare Industrieanlage, die eine Mehrzahl von Modulen umfasst, wobei das Verfahren umfasst:
ein Verfahren zum Simulieren eines Modulbetriebs eines Moduls der modularen Industrieanlage, umfassend:
Bereitstellen eines Ausgangsmodells für das Modul (S11) auf Grundlage einer Simulation, insbesondere einer White-Box-Simulation oder einer Black-Box-Simulation oder einer Grey-Box-Simulation,
Durchführen eines wissensbasierten Verbesserungsschritts (S12), umfassend ein Erhalten eines verbesserten Modells durch Durchführen einer wissensbasierten Modifikation des Ausgangsmodells und/oder einer wissensbasierten Erweiterung des Ausgangsmodells, wobei die wissensbasierte Modifikation und/oder die wissensbasierte Erweiterung jeweils Domänenwissen modelliert und/oder Domänenregeln durchsetzt, und
Simulieren (S14) des Modulbetriebs des Moduls mittels des verbesserten Modells;
wobei das Verfahren zur Bestimmung von Steuerungsparametern für die modulare Industrieanlage ferner umfasst:
Modellieren (S15) von Wechselbeziehungen zwischen Modulen der modularen Industrieanlage; und
auf Grundlage des simulierten Modulbetriebs des Moduls und der modellierten Wechselbeziehungen Durchführen (S16) eines Optimierungsschritts, um Steuerungsparameter für die modulare Industrieanlage bereitzustellen.

2. Computerimplementiertes Verfahren zur Bestimmung von Steuerungsparametern für eine modulare Industrieanlage, die eine Mehrzahl von Modulen umfasst, wobei das Verfahren umfasst:
ein Verfahren zum Simulieren eines Modulbetriebs eines Moduls der modularen Industrieanlage, umfassend:
Bereitstellen eines Ausgangsmodells für das Modul (S11) auf Grundlage einer Simulation, insbesondere einer White-Box-Simulation oder einer Black-Box-Simulation,
Durchführen eines datengetriebenen Verbesserungsschritts (S13), umfassend ein Erhalten eines verbesserten Modells durch Durchführen einer datengetriebenen Modifikation des Ausgangsmodells und/oder einer datengetriebenen Erweiterung des Ausgangsmodells, wobei die datengetriebene Modifikation und/oder die datengetriebene Erweiterung jeweils auf Messdaten basiert, die für das im Betrieb befindliche, als Teil der modularen Industrieanlage installierte Modul erhalten wurden, und
Simulieren (S14) des Modulbetriebs des Moduls mittels des verbesserten Modells;
wobei das Verfahren zur Bestimmung von Steuerungsparametern für die modulare Industrieanlage ferner umfasst:
Modellieren (S15) von Wechselbeziehungen zwischen Modulen der modularen Industrieanlage; und
auf Grundlage des simulierten Modulbetriebs des Moduls und der modellierten Wechselbeziehungen Durchführen (S16) eines Optimierungsschritts, um Steuerungsparameter für die modulare Industrieanlage bereitzustellen.

3. Computerimplementiertes Verfahren zur Bestimmung von Steuerungsparametern für eine modulare Industrieanlage, die eine Mehrzahl von Modulen umfasst, wobei das Verfahren umfasst: ein Verfahren zum Simulieren eines Modulbetriebs eines Moduls der modularen Industrieanlage, umfassend:
Bereitstellen eines Ausgangsmodells für das Modul (S11) auf Grundlage einer Simulation, insbesondere einer White-Box-Simulation oder einer Black-Box-Simulation,
Durchführen eines wissensbasierten Verbesserungsschritts (S12), umfassend ein Erhalten eines ersten verbesserten Modells durch Durchführen einer wissensbasierten Modifikation des Ausgangsmodells und/oder einer wissensbasierten Erweiterung des Ausgangsmodells, wobei die wissensbasierte Modifikation und/oder die wissensbasierte Erweiterung jeweils Domänenwissen modelliert und/oder Domänenregeln durchsetzt,
Durchführen eines datengetriebenen Verbesserungsschritts (S13), umfassend ein Erhalten eines zweiten verbesserten Modells durch Durchführen einer datengetriebenen Modifikation des ersten verbesserten Modells, wobei die datengetriebene Modifikation und/oder die datengetriebene Erweiterung jeweils auf Messdaten basiert, die für das im Betrieb befindliche, als Teil der modularen Industrieanlage installierte Modul erhalten wurden, und
Simulieren (S14) des Modulbetriebs des Moduls mittels des zweiten verbesserten Modells;
wobei das Verfahren zur Bestimmung von Steuerungsparametern für die modulare Industrieanlage ferner umfasst:
Modellieren (S15) von Wechselbeziehungen zwischen Modulen der modularen Industrieanlage; und
auf Grundlage des simulierten Modulbetriebs des Moduls und der modellierten Wechselbeziehungen Durchführen (S16) eines Optimierungsschritts, um Steuerungsparameter für die modulare Industrieanlage bereitzustellen.

4. Verfahren nach Anspruch 3, wobei als Teil des wissensbasierten Verbesserungsschritts eine regelbasierte Korrektur von Verzerrungen und/oder Randfällen durchgeführt wird und anschließend, als Teil des datengetriebenen Verbesserungsschritts, eine Datenassimilation zur Kalibrierung des ersten verbesserten Modells und/oder zur Kalibrierung einer oder mehrerer Regeln der regelbasierten Korrektur von Verzerrungen und/oder Randfällen durchgeführt wird.

5. Verfahren nach Anspruch 1, 3 oder 4, wobei der wissensbasierte Verbesserungsschritt auf modulspezifischem Wissen basiert, das wenigstens eines der folgenden umfasst: Informationen über eine Korrelation zwischen mehreren Variablen, Informationen über ein lineares oder nichtlineares funktionales Verhalten, Informationen über Abhängigkeiten, Informationen über Randfälle, Informationen über Verzerrungen in Eingangsdaten, Informationen über potenziell relevante zusätzliche Simulationsparameter.

6. Verfahren nach Anspruch 5, wobei das Modellieren von Domänenwissen ein Modellieren des modulspezifischen Wissens umfasst und/oder wobei das Durchsetzen von Domänenregeln ein Durchsetzen von Regeln umfasst, die das modulspezifische Wissen implementieren.

7. Verfahren nach einem der Ansprüche 2 bis 6, wobei der datengetriebene Verbesserungsschritt ein Durchführen einer datengetriebenen Modifikation und/oder Erweiterung umfasst, die eine Datenassimilation umfasst, die dazu eingerichtet ist, eine Differenz zwischen Simulationsausgabedaten und tatsächlichen Messdaten zu minimieren, beispielsweise unter Verwendung eines Kalman-Filters.

8. Verfahren nach einem der Ansprüche 2 bis 7, wobei der datengetriebene Verbesserungsschritt ein Durchführen einer datengetriebenen Modifikation und/oder Erweiterung umfasst, die nach Installation eines Moduls eine modulspezifische Kalibrierung des Ausgangsmodells, insbesondere von Simulationsparametern des Ausgangsmodells und/oder Beziehungen des Ausgangsmodells, umfasst.

9. Verfahren nach einem der vorhergehenden Ansprüche, wobei der Optimierungsschritt eine datengetriebene Optimierung auf Grundlage von Simulationsdaten und/oder Messdaten umfasst, die für den Betrieb der modularen Industrieanlage erhalten wurden.

10. System (1), umfassend ein Rechensystem (2), das dazu eingerichtet ist, das Verfahren nach einem der Ansprüche 1 bis 9 auszuführen.

11. System nach Anspruch 10, wobei das System ferner einen oder mehrere Sensoren (3) umfasst, die dazu eingerichtet sind, Messdaten für das im Betrieb befindliche, als Teil der modularen Industrieanlage installierte Modul und/oder Messdaten für die im Betrieb befindliche modulare Industrieanlage zu erfassen.

12. System nach Anspruch 10 oder 11, ferner umfassend das Modul (4) der modularen Industrieanlage (5).

13. Computerprogrammprodukt, umfassend Anweisungen, die, wenn das Programm durch ein Rechensystem ausgeführt wird, das Rechensystem veranlassen, das Verfahren nach einem der Ansprüche 1 bis 9 auszuführen.

14. Computerlesbares Medium, umfassend Anweisungen, die, wenn sie durch ein Rechensystem ausgeführt werden, das Rechensystem veranlassen, das Verfahren nach einem der Ansprüche 1 bis 9 auszuführen.

## Revendications

1. Procédé mis en œuvre par ordinateur de détermination de paramètres de contrôle d'installation modulaire d'une installation modulaire comprenant une pluralité de modules, le procédé comprenant :
un procédé de simulation du fonctionnement d'un module de l'installation modulaire comprenant les étapes suivantes
fournir un modèle initial pour le module (S11) sur la base d'une simulation, en particulier une simulation en mode boîte blanche, une simulation en mode boîte noire ou une simulation en mode boîte grise,
réaliser une étape d'amélioration basée sur les connaissances (S12), comprenant l'obtention d'un modèle amélioré en effectuant une modification basée sur les connaissances du modèle initial et/ou une extension basée sur les connaissances du modèle initial, où la modification basée sur les connaissances et/ou l'extension basée sur les connaissances modélisent chacune les connaissances du domaine et/ou appliquent les règles du domaine, et
simuler (S14) un fonctionnement du module au moyen du modèle amélioré ;
le procédé de détermination de paramètres de contrôle d'une installation modulaire comprenant en outre les étapes suivantes :
modéliser (S15) des interrelations entre les modules de l'installation modulaire ; et
sur la base du fonctionnement simulé du module et des interrelations modélisées, exécuter (S16) une étape d'optimisation afin de fournir des paramètres de contrôle d'installation modulaire.

2. Procédé mis en œuvre par ordinateur de détermination de paramètres de contrôle d'installation modulaire d'une installation modulaire comprenant une pluralité de modules, le procédé comprenant :
un procédé de simulation du fonctionnement d'un module de l'installation modulaire comprenant les étapes suivantes
fournir un modèle initial pour le module (S11) sur la base d'une simulation, en particulier une simulation en mode boîte blanche ou une simulation en mode boîte noire, réaliser une étape d'amélioration pilotée par des données (S13), comprenant l'obtention d'un modèle amélioré en effectuant une modification pilotée par des données du modèle initial et/ou une extension pilotée par des données du modèle initial, où la modification pilotée par des données et/ou l'extension pilotée par des données sont chacune basées sur des données de mesure obtenues pour le module en fonctionnement installé en tant que partie de l'installation modulaire, et
simuler (S14) un fonctionnement du module au moyen du modèle amélioré ;
le procédé de détermination de paramètres de contrôle d'une installation modulaire comprenant en outre les étapes suivantes :
modéliser (S15) des interrelations entre les modules de l'installation modulaire ; et
sur la base du fonctionnement simulé du module et des interrelations modélisées, exécuter (S16) une étape d'optimisation afin de fournir des paramètres de contrôle d'installation modulaire.

3. Procédé mis en œuvre par ordinateur de détermination de paramètres de contrôle d'installation modulaire d'une installation modulaire comprenant une pluralité de modules, le procédé comprenant :
un procédé de simulation du fonctionnement d'un module de l'installation modulaire comprenant les étapes suivantes
fournir un modèle initial pour le module (S11) sur la base d'une simulation, en particulier une simulation en mode boîte blanche ou une simulation en mode boîte noire, réaliser une étape d'amélioration basée sur les connaissances (S12), comprenant l'obtention d'un premier modèle amélioré en effectuant une modification basée sur les connaissances du modèle initial et/ou une extension basée sur les connaissances du modèle initial, où la modification basée sur les connaissances et/ou l'extension basée sur les connaissances modélisent chacune les connaissances du domaine et/ou appliquent les règles du domaine,
réaliser une étape d'amélioration pilotée par des données (S13), comprenant l'obtention d'un deuxième modèle amélioré en effectuant une modification pilotée par des données du premier modèle amélioré, où la modification pilotée par des données et/ou l'extension pilotée par des données sont chacune basées sur des données de mesure obtenues pour le module en fonctionnement installé en tant que partie de l'installation modulaire, et
simuler (S14) un fonctionnement du module au moyen du deuxième modèle amélioré ;
le procédé de détermination de paramètres de contrôle d'une installation modulaire comprenant en outre les étapes suivantes :
modéliser (S15) des interrelations entre les modules de l'installation modulaire ; et
sur la base du fonctionnement simulé du module et des interrelations modélisées, exécuter (S16) une étape d'optimisation afin de fournir des paramètres de contrôle d'installation modulaire.

4. Procédé selon la revendication 3, dans lequel, en tant que partie de l'étape d'amélioration basée sur les connaissances, une correction de biais et/ou des cas limites basée sur des règles est effectuée, et ensuite, en tant que partie de l'étape d'amélioration pilotée par des données, une assimilation de données est effectuée pour l'étalonnage du premier modèle amélioré et/ou pour l'étalonnage d'une ou plusieurs règles de la correction de biais et/ou des cas limites basée sur des règles.

5. Procédé selon les revendications 1, 3 ou 4, dans lequel l'étape d'amélioration basée sur les connaissances est basée sur des connaissances spécifiques au module comprenant au moins une information parmi des informations sur la corrélation entre plusieurs variables, des informations sur le comportement fonctionnel linéaire ou non linéaire, des informations sur les interdépendances, des information sur les cas limites, des informations sur des biais dans les données d'entrée, des information sur des paramètres de simulation supplémentaires potentiellement pertinents.

6. Procédé selon la revendication 5, dans lequel la modélisation de la connaissance du domaine comprend la modélisation de la connaissance spécifique au module et/ou dans lequel l'application de règles de domaine comprend l'application de règles qui implémentent la connaissance spécifique au module.

7. Procédé selon l'une quelconque des revendications 2 à 6, dans lequel l'étape d'amélioration pilotée par des données comprend l'exécution d'une modification pilotée par des données et/ou une extension qui comprend une assimilation de données configurée pour minimiser une différence entre des données de sortie de simulation et des données de mesure réelles, par exemple en utilisant un filtre de Kalman.

8. Procédé selon l'une quelconque des revendications 2 à 7, dans lequel l'étape d'amélioration pilotée par les données comprend la réalisation d'une modification pilotée par les données et/ou d'une extension comprenant, après installation d'un module, un étalonnage spécifique au module du modèle initial, en particulier des paramètres de simulation de modèle initial et/ou des relations de modèle initial.

9. Procédé selon l'une quelconque des revendications précédentes, dans lequel l'étape d'optimisation comprend une optimisation pilotée par des données basée sur des données de simulation et/ou des données de mesure obtenues pour le fonctionnement d'une installation modulaire.

10. Système (1) comprenant un système informatique (2) configuré pour mettre en œuvre le procédé selon l'une quelconque des revendications 1 à 9.

11. Système selon la revendication 10, le système comprenant en outre un ou plusieurs capteurs (3) configurés pour obtenir des données de mesure pour le module en fonctionnement étant installé dans le cadre de l'installation industrielle modulaire et/ou des données de mesure pour l'installation modulaire en fonctionnement.

12. Système selon les revendications 10 ou 11, comprenant en outre le module (4) de l'installation industrielle modulaire (5).

13. Produit programme d'ordinateur comprenant des instructions qui, lorsque le programme est exécuté par un système informatique, amènent le système informatique à mettre en œuvre le procédé selon l'une quelconque des revendications 1 à 9.

14. Support lisible par ordinateur comprenant des instructions qui, lorsqu'elles sont exécutées par un système informatique, amènent le système informatique à mettre en œuvre le procédé selon l'une quelconque des revendications 1 à 9.
